# DEMANDE DE BREVET EUROPEEN

(11) **EP 2 107 602 A1**
(43) Date de publication de la demande: **07.10.2009**
(21) Numéro de dépôt: 09290212.1
(22) Date de dépôt: 20.03.2009
(51) Int. Cl.: H01L 21/762

(54) **Procédé de fabrication d'une structure micro-électronique du type à semi-conducteur sur isolant et à motifs différenciés**

(30) Priorité: 31.03.2008 FR 0852106
(71) Demandeur: Commissariat à l'Energie Atomique, Bâtiment D "Le Ponant" 25 rue Leblanc 75015 Paris (FR)
(72) Inventeur: Augendre, Emmanuel, 38330 Montbonnot (FR); Ernst, Thomas, 38210 Morette (FR); Kostrzewa, Marek, 38100 Grenoble (FR); Moriceau, Hubert, 38120 Saint-Egreve (FR)
(74) Mandataire: Quantin, Bruno Marie Henri

(57) **Abrégé**

Pour fabriquer une microstructure du type à semi-conducteur sur isolant et à motifs différenciés :
- on réalise une structure empilée uniforme 10 comportant une plaque formant substrat 11, une couche isolante continue et une couche semi-conductrice 15, cette couche isolante continue étant formée d'un empilement d'au moins trois couches élémentaires, dont une couche élémentaire inférieure 12, au moins une couche élémentaire intermédiaire 13 et une couche élémentaire supérieure 14 longeant la couche semi-conductrice, l'une au moins parmi la couche élémentaire inférieure et la couche élémentaire supérieure étant en un matériau isolant, puis
- on forme, dans cette structure empilée uniforme, une pluralité d'au moins deux motifs (M1 à M4) différenciés en modifiant l'une des couches élémentaires au sein de l'un de ces motifs de manière à ce que cette couche élémentaire présente une différence sensible de nature physique ou chimique entre ces deux motifs, l'une au moins des couches élémentaires inférieure ou supérieure qui est en matériau isolant restant inchangée.

## Description

L'invention concerne la réalisation d'une structure microélectronique de type à semi-conducteur sur isolant et comportant des motifs différenciés, mettant en oeuvre la formation, sur un même substrat, de motifs ayant par exemple des conductibilités électriques ou thermiques différentes et étant activables indépendamment.

### Domaine technique

L'abréviation « SOI » désigne du silicium sur un isolant (ou « Silicon On Insulator » en anglais, d'où l'abréviation « SOI »). Le SOI est un cas particulier (d'intérêt pratique important) d'une famille plus générale de produits, comportant un matériau semi-conducteur sur un isolant. Les substrats du type à semi-conducteur sur isolant sont ainsi constitués d'un empilement d'un film semi-conducteur mince sur un isolant, lui-même reposant sur un substrat. Ils ont émergé en tant qu'alternative aux substrats semi-conducteurs massifs grâce à leurs propriétés originales d'isolation électrique et de tenue aux radiations.

Dans le contexte ici considéré, SOI peut aussi bien désigner du silicium sur isolant que, par extension, du semi-conducteur sur isolant.

Parmi les structures SOI qui sont examinées actuellement en vue d'une industrialisation future, on peut citer les substrats suivants :
- les substrats à isolant ultramince (jusqu'à une dizaine de nanomètres) permettant d'optimiser l'intégrité électrostatique,
- les substrats à isolant dit « exotique » (par exemple nitrure de silicium, alumine, diamant, ou empilement de telles couches au lieu de la silice massive habituelle) permettant d'améliorer l'évacuation de la chaleur ou permettant le piégeage de charges, et
- les substrats où l'épaisseur de l'isolant n'est pas uniforme pour répondre au mieux aux contraintes de l'intégration de systèmes hétérogènes.

### Etat de la technique

Aujourd'hui, ces substrats spécifiques peuvent être fabriqués (et commercialisés) par collage moléculaire de deux substrats l'un à l'autre, suivi d'un amincissement, par exemple par meulage, de l'un d'entre eux (procédés BSOI - c'est-à-dire « Bonded SOI », BESOI - c'est-à-dire Bonded and Etched-Back SOI, ou procédé « Eltran » - c'est-à-dire « Epitaxial Layer Transfer »). Ces procédés présentent l'inconvénient de consommer deux substrats pour en fabriquer un seul (un des substrats étant en grande partie consommé durant l'étape d'amincissement).

Parallèlement, le procédé « Smart Cut » ^{™} est un procédé de fabrication de substrats SOI conventionnels (avec de la silice utilisée comme isolant d'épaisseur supérieure à 50 nm), qui est dominant à l'heure actuelle tant pour des raisons de coût que de qualité du matériau. En résumé, ce procédé « Smart Cut » ^{™} consiste, par exemple, à implanter une espèce donnée à une profondeur donnée au sein d'un substrat à la surface duquel on forme une couche d'oxyde formant isolant et à coller un second substrat sur la surface munie de la couche d'isolant. Il s'agit souvent d'un collage moléculaire, avantageusement suivi d'un traitement thermique de consolidation. Ensuite, une fracture est provoquée au niveau de la couche implantée, en pratique au moins en partie par un traitement thermique, de sorte qu'on obtient un substrat (le second substrat précité), auquel est rapporté par collage une couche fine du premier substrat précité, longeant la couche d'isolant.

Toutefois, les diverses approches connues présentent diverses limites.

C'est ainsi que le procédé « Smart Cut »^{™} comporte une étape de fracture, nécessaire pour séparer le substrat SOI du reste du substrat donneur, qui n'existe pas dans les autres procédés (BSOI, BESOI, Eltran...) ; il est vrai que cette étape additionnelle permet de réutiliser le reste du substrat donneur, à la différence des autres procédés dans lesquels l'amincissement consomme complètement l'un des substrats, en dehors du film faisant partie de la structure SOI finale. Toutefois, cette étape spécifique du procédé « Smart Cut »^{™} peut créer une défectivité spécifique si des précautions particulières ne sont pas prises, par exemple dans le cas de certains isolants minces, lorsque de l'eau est emprisonnée à l'étape de collage.

En pratique, l'isolant d'un substrat SOI peut comporter, le long du substrat, des variations d'épaisseur ; en effet, le produit final peut comporter classiquement divers motifs dont les caractéristiques spécifiques (notamment en ce qui concerne son isolant) dépendent du rôle futur spécifique de ces motifs. Actuellement, la fabrication d'un substrat dont l'isolant n'est pas uniforme en épaisseur est déterminée par l'utilisation ultérieure qui en sera faite : les différences concernant les isolants des divers motifs sont créées pendant la fabrication du substrat, suivant un schéma déterminé par le produit final. Cette spécificité limite la versatilité du substrat (dès sa fabrication, il n'est plus utilisable que dans l'application visée, ce qui empêche en pratique de fabriquer des substrats sans en connaître au préalable la destination) et introduit, dès la fabrication du substrat, des étapes de photolithographie et de gravure (habituellement réservées à l'élaboration des circuits intégrés) qui contraignent les fabricants de substrats à étendre leur parc d'équipements et leur savoir-faire technologique pour pouvoir effectuer ces étapes. De plus, les utilisateurs des substrats doivent partager des informations sur l'utilisation de leurs produits avec leurs fournisseurs de substrats, ce qui peut nuire à la confidentialité concernant la destination de substrats commandés à ces fournisseurs.

### Problème technique et objet de l'invention

L'invention a pour objet la fabrication d'une structure microélectronique du type à semi-conducteur sur isolant ayant des motifs différenciés, permettant de ne prendre en compte les spécificités de la structure à réaliser (notamment en ce qui concerne les caractéristiques de conductivité électrique et/ou thermique des isolants des motifs visés) qu'après une étape de fabrication d'un substrat uniforme. Il faut noter que, par « uniforme », on entend uniforme à l'échelle d'au moins deux motifs différenciés. Ainsi l'uniformité peut être à l'échelle d'une pluralité de motifs, voire à l'échelle d'une portion du substrat, voire à l'échelle du substrat tout entier.

Elle vise en outre, à titre subsidiaire, que cette fabrication initiale puisse être réalisée par application d'un procédé tel que le procédé « Smart Cut »^{™}, sans avoir à se restreindre dans le choix de l'isolant.

L'invention propose à cet effet un procédé de fabrication d'une microstructure du type à semi-conducteur sur isolant et à motifs différenciés, comportant des étapes selon lesquelles :
- on réalise une structure empilée uniforme du type à semi-conducteur sur isolant comportant une plaque formant substrat, une couche isolante continue longeant ce substrat et une couche semi-conductrice longeant cette couche isolante en étant séparée du substrat par cette couche isolante, cette couche isolante continue étant formée d'un empilement d'au moins trois couches élémentaires, dont une couche élémentaire inférieure, au moins une couche élémentaire intermédiaire et une couche élémentaire supérieure longeant la couche semi-conductrice, l'une au moins parmi la couche élémentaire inférieure et la couche élémentaire supérieure étant en un matériau (électriquement) isolant, puis
- on forme, dans cette structure empilée uniforme, une pluralité d'au moins deux motifs différenciés en modifiant l'une des couches élémentaires au sein de l'un de ces motifs de manière à ce que cette couche élémentaire présente une différence sensible de nature physique ou chimique entre ces deux motifs, l'une au moins des couches élémentaires inférieure ou supérieure qui est en matériau isolant restant inchangée dans ces deux motifs.

On comprend ainsi que, du fait de la mise en oeuvre d'une structure empilée uniforme intermédiaire, on peut distinguer deux étapes, à savoir une étape de fabrication de la structure empilée uniforme (effectuée chez le fabricant) et une étape de modification ou de spécialisation ou de personnalisation (pouvant être effectuée chez l'utilisateur final). Il en résulte des économies en termes de fabrication et de stockage.

Après cette première étape, on peut librement différencier les motifs en changeant la (ou les) couche(s) élémentaire(s). On parlera indifféremment de changement, ou d'adaptation, ou de modification, ou de modulation, de cette couche pour qualifier la modification locale de la nature physique et/ou chimique de cette couche, y compris sa suppression ou son remplacement par un autre matériau.

Enfin, dans la mesure où cette structure empilée uniforme comporte une couche isolante formée d'un empilement d'au moins deux couches dont l'une longe le substrat et l'autre longe la couche semi-conductrice, on peut choisir des matériaux différents pour ces deux couches, en sorte notamment de permettre un bon collage entre la couche élémentaire supérieure et la couche semi-conductrice et entre la couche élémentaire inférieure et le substrat. Le choix des matériaux des couches élémentaires inférieures et supérieures, dont l'un au moins est un isolant, peut aussi être fait en fonction des étapes à effectuer lors de la spécialisation, par exemple en liaison avec des opérations d'attaque humide.

De manière avantageuse, les couches élémentaires inférieure et supérieure sont toutes deux en un matériau isolant ; il peut s'agir d'un même matériau isolant pour les deux couches, ou de matériaux différents.

De manière également avantageuse, c'est la couche élémentaire intermédiaire que l'on modifie.

II faut noter que, de préférence, on ne modifie qu'une seule couche élémentaire pour différencier les motifs de la structure finale, mais que les modifications peuvent, en variante, affecter plus d'une couche élémentaire.

De manière avantageuse, on forme la structure empilée uniforme selon des étapes selon lesquelles :
* on prépare un premier substrat en un matériau semi-conducteur,
* on prépare un second substrat,
* on forme sur le premier et/ou le second substrat les couches élémentaires dudit empilement,
* on assemble par collage, avantageusement un collage moléculaire, le premier substrat et le second substrat en sorte que l'empilement se retrouve entre les deux substrats, la couche élémentaire supérieure longeant le premier substrat et la couche élémentaire inférieure longeant le second substrat,
* on amincit le premier substrat semi-conducteur en sorte de former ladite couche semi-conductrice solidaire dudit empilement.

Cet amincissement peut être un amincissement mécano-chimique ou résulter d'une fracture au niveau d'une zone fragile enterrée du substrat préalablement formée, avantageusement formée avant l'étape de collage, par exemple une zone poreuse ou encore une zone fragile créée par implantation d'une ou plusieurs espèces gazeuses.

Cela permet de tirer profit des avantages d'un procédé de formation d'une couche mince tel que le procédé « Smart Cut »^{™} pour la formation de la couche semi-conductrice, tout en conservant une grande latitude dans le choix des matériaux, notamment ceux de l'empilement.

Selon d'autres caractéristiques avantageuses du procédé de l'invention, éventuellement combinées :
- ladite couche élémentaire que l'on modifie au sein d'un motif est en matériau semi-conducteur et la modification de cette couche élémentaire dudit motif comporte une étape de dopage, ce qui permet aisément (par exemple par bombardement ionique et activation thermique) de modifier des caractéristiques de conductivité électrique,
- ladite couche élémentaire que l'on modifie au sein d'un motif est en matériau semi-conducteur et la modification de cette couche élémentaire dudit motif comporte une étape d'introduction d'éléments d'alliage (ce qui peut aussi s'obtenir par bombardement ou par diffusion), ce qui permet, par un choix des propriétés respectives (par exemple de conductivité électrique et/ou thermique) du matériau initial et de l'élément d'alliage, d'ajuster les propriétés des couches globales d'isolant (formées par les empilements) ainsi réalisées et modifiées,
- ladite couche élémentaire que l'on modifie au sein d'un motif est en matériau semi-conducteur ou en métal et la modification de cette couche élémentaire dudit motif comporte une étape consistant à changer la phase cristalline du matériau de cette couche élémentaire (aux diverses phases d'un matériau peuvent correspondre des propriétés électriques ou thermiques différentes, par exemple dans le cas du carbone selon qu'il est cristallin ou amorphe), par exemple par chauffage localisé, par exemple par laser,
- ladite modification de la couche élémentaire d'un motif comporte une étape consistant à retirer localement ladite couche élémentaire, éventuellement suivie d'une étape consistant à remplir par un nouveau matériau l'espace laissé par le retrait local de la couche élémentaire, ce qui permet, grâce à la mise en oeuvre de procédés classiques du domaine de la microélectronique, d'obtenir des couches élémentaires constituées, selon les endroits, en des matériaux complètement différents.

Bien entendu les différents types de modification peuvent être combinés au sein d'une même structure ; ces modifications concernent de préférence une même couche élémentaire de la structure empilé, mais l'invention se généralise aux cas où des modifications affectent plusieurs couches élémentaires (il peut y avoir une seule modification par motif, voire deux ou plusieurs modifications au sein de certains des motifs).

Une structure obtenue par le procédé précité est reconnaissable par le fait qu'il s'agit d'une structure empilée du type à semi-conducteur sur isolant comportant, sur un substrat porteur, une pluralité de motifs comportant chacun une zone isolante longeant le substrat et une zone semi-conductrice séparée du substrat par cette zone isolante, **caractérisée en ce que** les zones isolantes d'au moins deux desdits motifs de la pluralité sont chacune formées d'un empilement d'au moins trois couches élémentaires, dont une couche élémentaire inférieure longeant le substrat et formée en un premier matériau, au moins une couche élémentaire intermédiaire, et une couche élémentaire supérieure longeant la zone semi-conductrice formée en un second matériau, au moins l'un des premier et second matériaux étant un matériau isolant, deux couches élémentaires des zones isolantes desdits deux motifs occupant respectivement une même place dans les empilements constitutifs de ces deux motifs présentant une différence sensible de nature physique ou chimique, ledit matériau isolant étant le même dans les zones isolantes desdits deux motifs.

On comprend aisément qu'une telle structure empilée permet d'obtenir des motifs différenciés, c'est-à-dire présentant des propriétés différentes, tout en ne différant, principalement, que par la constitution de l'une de leurs couches élémentaires ; il en découle notamment les avantages mentionnés ci-dessus à propos du procédé.

Selon des caractéristiques avantageuses de cette structure selon l'invention, éventuellement combinées (correspondant en pratique à celles mentionnées à propos du procédé ci-dessus) :
- la différence entre lesdites couches élémentaires des zones isolantes résulte en une différence de conductivité électrique et/ou thermique,
- lesdites couches élémentaires des zones isolantes desdits deux motifs sont respectivement formées en un matériau semi-conducteur ou en métal, et en un matériau isolant ou du vide,
- lesdites couches élémentaires des zones isolantes desdits deux motifs sont respectivement formées en un premier matériau et en ce même matériau ayant subi un dopage ; de manière avantageuse, ce premier matériau est électriquement résistif,
- lesdites couches élémentaires des zones isolantes desdits deux motifs sont respectivement formées en un premier matériau et en du vide,
- lesdites couches élémentaires des zones isolantes desdits deux motifs sont respectivement formées en un premier matériau, et en un autre matériau consistant en un alliage du premier matériau avec un autre élément chimique ; de manière avantageuse, le premier matériau est un matériau résistif et ledit autre élément chimique est un élément métallique,
- lesdites couches élémentaires des zones isolantes desdits deux motifs sont respectivement formées en un même matériau ayant deux phases cristallines différentes

Il ressort de ce qui précède que l'un des aspects de l'invention concerne la structure empilée uniforme intermédiaire que le procédé précité met en oeuvre pour aboutir à la structure définie ci-dessus, notamment lorsque les couches élémentaires inférieure et supérieure sont toutes deux en matériau isolant.

Selon cet aspect, l'invention propose une structure empilée uniforme comportant une plaque formant substrat, une couche isolante continue longeant ce substrat et une couche semi-conductrice longeant cette couche isolante en étant séparée du substrat par cette couche isolante, **caractérisé en ce que** cette couche isolante continue est formée d'un empilement d'au moins trois couches élémentaires, dont une couche élémentaire inférieure en un premier matériau isolant qui longe la plaque formant substrat, au moins une couche élémentaire intermédiaire et une couche élémentaire supérieure en un second matériau isolant longeant la couche semi-conductrice.

### Description de l'invention

Des objets, caractéristiques et avantages de l'invention ressortent de la description qui suit, donnée à titre d'exemple illustratif non limitatif, en regard des dessins annexés sur lesquels :
- la figure 1 est un schéma d'une structure empilée uniforme du type à semi-conducteur sur isolant conforme à l'invention, prête à être personnalisée en vue d'obtenir une structure microélectronique particulière conforme à l'invention, par la mise en oeuvre du procédé de l'invention,
- la figure 2 est un schéma de principe d'une structure microélectronique du type à semi-conducteur sur isolant et à motifs différenciés, obtenue à partir de la structure empilée de la figure 1 par la mise en oeuvre de l'invention,
- les figures 3A à 3F représentent des étapes successives d'un procédé de fabrication de la structure empilée de la figure 1,
- les figures 4A à 4G représentent des étapes successives d'un procédé adapté à fabriquer une structure microélectronique particulière conforme au schéma de principe de la figure 2, et
- la figure 5 est un schéma d'une microstructure classique à laquelle la structure obtenue par le procédé des figures 4A à 4G peut être substituée.

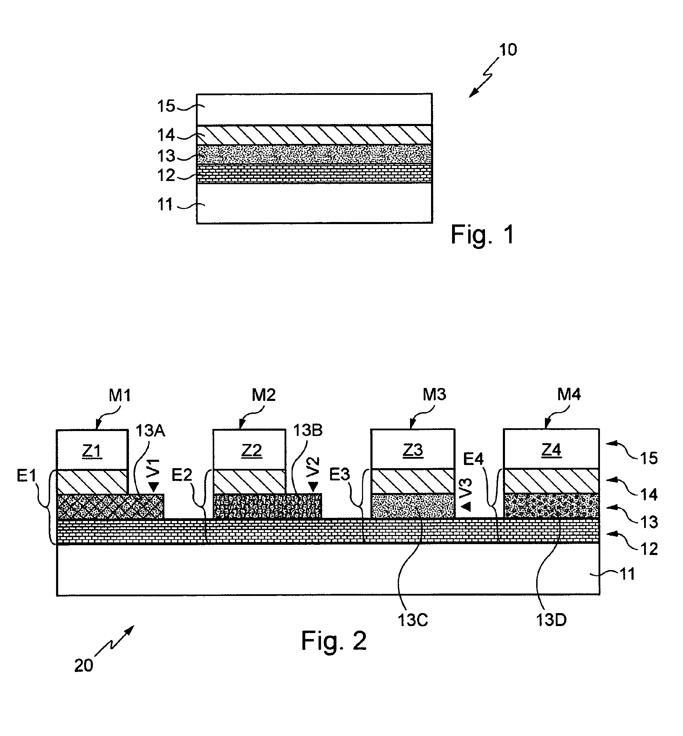

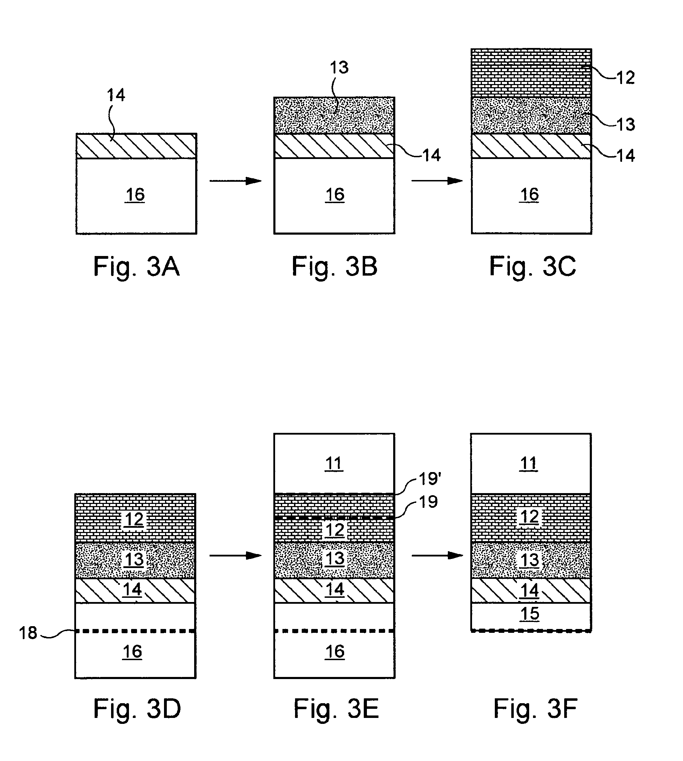

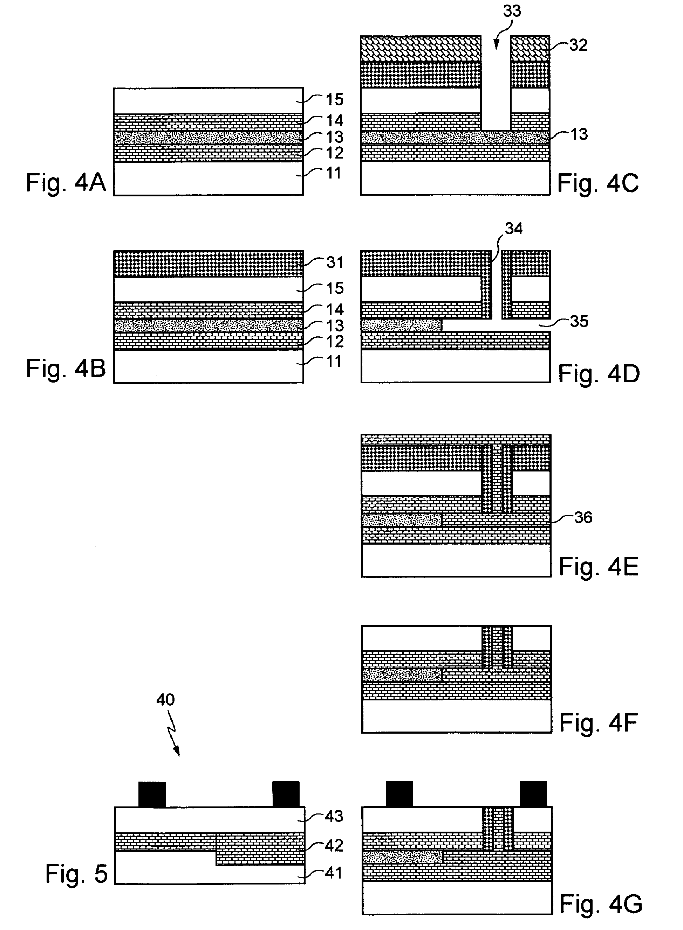

Les figures annexées représentent ainsi trois aspects de l'invention, puisque la figure 1 décrit une structure empilée uniforme (il n'y a encore aucun motif), les figures 3A à 3F et 4A à 4G décrivent un procédé mettant en oeuvre une telle structure et la figure 2 (il en est de même de la figure 4G) représente une structure finale résultant de l'application du procédé à la structure empilée uniforme.

On peut dire que la structure empilée uniforme est universelle en ce sens qu'elle est encore indépendante de la destination finale de la structure particulière qui va être obtenue à partir de cette structure ; elle est donc capable d'être spécialisée, ou personnalisée, ou modifiée en fonction d'une très grande variété d'utilisations futures.

Le fait de dire que cette structure est uniforme traduit que les diverses couches qui la constituent sont continues et d'épaisseurs sensiblement constantes sur des distances supérieures à celles d'au moins deux motifs voire d'une portion du substrat, voire du substrat tout entier, c'est-à-dire typiquement à une échelle supérieure au centimètre, voire à quelques dizaines de centimètres, ce qui permet de dire qu'il s'agit d'une plaque dont la partie utile comporte l'empilement de couches continues et constantes précité.

Plus précisément la figure 1 représente une structure empilée du type à semi-conducteur sur isolant, représenté sous la référence générale 10. Il comporte un substrat 11, par exemple de la taille d'une plaque, surmonté d'un empilement de couches 12, 13 et 14 dont l'une au moins parmi les couches extrêmes 12, 14 est isolante, puis d'un film semi-conducteur 15.

Une telle structure se distingue d'un substrat SOI classique par le fait que, entre le substrat et le film semi-conducteur, l'isolant massif est remplacé par un empilement de couches élémentaires dont au moins l'une parmi les couches extrêmes est en matériau isolant. Dans l'exemple considéré, les deux couches extrêmes sont toutes deux en matériau isolant : la couche inférieure 12, qui longe la plaque 11, est en un premier matériau isolant, tandis que la couche supérieure 14, qui longe le film semi-conducteur 15, est en un second matériau isolant, le premier et le second matériaux isolants pouvant être les mêmes ou différents. Ces diverses couches ont des épaisseurs constantes.

Selon l'invention, ainsi que cela sera détaillé plus loin, au moins une des couches extrêmes qui est isolante reste inchangée lors de l'étape de modification de la structure empilée uniforme.

De préférence, le nombre de couches est impair, avec, de manière avantageuse, une alternance de couches isolantes et de couches conductrices (électriquement résistives mais ayant une conductivité électrique supérieure à celle des isolants) ; en d'autres termes, si N est un nombre entier, l'empilement peut comporter jusqu'à N+1 couches isolantes, alternant avec N couches en des matériaux quelconques pouvant donc être choisis en fonction d'autres critères. Dans l'exemple de la figure 1, le nombre N est égal à 1, ce qui correspond au cas d'application de l'invention le plus simple.

Plus généralement, il y a un empilement de couches dont l'une au moins, parmi la première et la dernière, est isolante, avec un nombre pair ou impair de couches élémentaires intermédiaires.

De manière avantageuse, on choisit, comme matériau de la couche 12 longeant le substrat 11, un matériau compatible avec l'utilisation d'un procédé tel que le procédé « Smart Cut »^{™} (une couche épaisse de silice par exemple). Ceci permet de rendre le choix du matériau de la couche supérieure indépendant des contraintes du procédé « Smart Cut »^{™}. On peut ainsi utiliser n'importe quel matériau (de n'importe quelle nature, dans n'importe quelle épaisseur) pour cette couche supérieure 14, suivant l'application visée pour la structure finale tout en conservant les bénéfices du procédé technologique.

Dans la suite, on utilisera l'expression de matériau modifiable pour le matériau constitutif de la couche élémentaire 12, 13 ou 14, pour traduire qu'on peut, lors de la personnalisation ultérieure, modifier la nature physique ou chimique de cette couche pour ainsi « adapter » localement les propriétés de cette couche, et donc les propriétés de l'empilement (12-13-14) en fonction des besoins.

Ainsi, conformément à l'invention, la présence du matériau modifiable d'une couche élémentaire permet, lors de la personnalisation (ou spécialisation) de la structure empilée 10, de créer des zones de différentes natures, notamment du point de vue de la conductivité électrique ou thermique de cette couche, en modifiant localement cette couche élémentaire 12, 13 ou 14, y compris en la remplaçant par du vide ou par un autre matériau. Ainsi, il est possible, après sa fabrication, de transformer la structure empilée uniforme 10 de la figure 1 en une structure où l'empilement isolant, pris dans son ensemble, n'est plus uniforme suivant les besoins de l'application, ainsi que cela est représenté à la figure 2.

Le matériau de la couche intermédiaire 13 est typiquement un semi-conducteur, par exemple du silicium (et plus particulièrement du silicium polycristallin) et le matériau de la couche supérieure 14 est avantageusement un oxyde du matériau constitutif de la couche intermédiaire sous-jacente (de la silice dans l'exemple du silicium). Quant au matériau de la couche inférieure 12, il est avantageusement formé d'un matériau choisi parmi les oxydes, les nitrures et les matériaux à grand gap électronique.

La figure 2 représente schématiquement une structure finale 20 du type à semi-conducteur sur isolant et à motifs différenciés, découlant de la structure empilée uniforme 10 de la figure 1 par des modifications locales du matériau constitutif de l'une des couches élémentaires (ici la couche intermédiaire 13).

On distingue ainsi, sur le même substrat porteur 11 qu'à la figure 1, quatre motifs notés M1, M2, M3 et M4.

On peut en effet identifier une pluralité de motifs comportant chacun une zone isolante longeant le substrat 11 et une portion de la zone semi-conductrice 15 séparée du substrat par cette zone isolante.

Le motif M3 résulte clairement de la simple délimitation d'un motif dans la structure empilée uniforme de la figure 1. C'est ainsi que sa zone isolante est formée d'un empilement E3 comportant une portion de la couche inférieure 12 de la figure 1, une portion de la couche intermédiaire 13 et une portion de la couche supérieure 14, tandis que sa zone semi-conductrice Z3 est une portion de la couche semi-conductrice 15 de la figure 1.

Dans l'exemple représenté à la figure 2, les autres motifs M1, M2 et M4 différent tous du motif M3, mais, dans l'exemple ici considéré, uniquement en ce qui concerne la couche intermédiaire 13. C'est ainsi que les zones isolantes E1 à E4 ont toutes sensiblement la même épaisseur, sont toutes formées d'un empilement d'un même nombre de couches, avec une couche inférieure longeant le substrat et formée en un même premier matériau (par exemple isolant) pour chaque motif sur une même épaisseur dans chaque motif, au moins une couche intermédiaire et une couche supérieure longeant la zone semi-conductrice et formée en un même second matériau (par exemple isolant, lui aussi) sur une même épaisseur au sein de chaque motif. En outre les zones semi-conductrices Z1 à Z4 sont formées d'un même matériau sur une même épaisseur (ce sont des portions de la couche 15).

En d'autres termes, les couches que l'on peut distinguer au sein de chaque motif sont dans le prolongement les unes des autres, lorsque l'on passe d'un motif à l'autre ; c'est notamment à cela qu'on reconnaît que la structure a été obtenue à partir d'une structure empilée telle que celle de la figure 1.

Dans l'exemple considéré, les portions de la couche inférieure 12 ne sont pas délimitées en fonction des motifs, puisque cette couche est encore continue, comme dans la figure 1. Bien entendu, en variante non représentée, ces portions appartenant respectivement aux motifs M1 à M4 peuvent être délimitées les unes par rapport aux autres.

Au moins l'un des motifs présente une différence sensible de nature physique ou chimique, au sein de l'une des couches élémentaires, ici la couche élémentaire intermédiaire 13. Il faut comprendre ici qu'il y a une différence sensible (ou substantielle) lorsque la différence est très supérieure aux habituelles fluctuations dans un procédé de fabrication donné et ne peut donc que découler d'une volonté délibérée de générer cette différence.

Il s'agit avantageusement d'une différence visant à générer une différence de conductivité électrique (mais il peut aussi s'agir d'une différence de conductivités à la fois électrique et thermique, voire uniquement thermique).

La couche intermédiaire a la même épaisseur globale dans chaque motif (même si la modification de cette couche, au sein d'au moins l'un d'entre eux, peut entrainer une légère différence d'épaisseur par rapport à la couche initiale).

Dans le cas ici considéré, trois exemples distincts de différence sont schématisés.

C'est ainsi que le motif M1 schématise ici le cas d'un motif qui diffère du motif M3 par le fait que le matériau de sa couche intermédiaire, désigné par la référence 13A, résulte du même matériau que celui du motif M3 (c'est-à-dire que celui de la couche 13 de la figure 1), par une altération, par exemple par dopage ou par alliage avec un élément additionnel (introduit par exemple par bombardement électronique de l'élément de dopage ou d'alliage et/ou par diffusion de cet élément, par exemple par un traitement thermique approprié).

Le motif M2 schématise le cas d'un autre motif qui diffère du motif M3 par le fait que le matériau de sa couche intermédiaire, désigné par la référence 13B, résulte du même matériau que celui du motif M3 par une altération également, mais avec une ampleur ou une nature différente de l'altération de la couche 13A du motif M1.

Quant au motif M4, il schématise le cas d'encore un autre motif qui diffère du motif M3 par le fait que le matériau de sa couche intermédiaire, désigné par la référence 13D, résulte d'une modification plus importante du matériau de la couche 13 d'origine, en ce sens qu'il y a eu retrait, par tout moyen connu approprié de la couche intermédiaire, à l'emplacement du motif (par exemple à partir des côtés formés lors de la délimitation des motifs), puis un éventuel remplacement par un matériau indépendant de celui de la couche 13 d'origine. On peut par exemple ainsi substituer au silicium de l'aluminium.

On comprend que chacune de ces modifications du matériau (qualifié ici de matériau modifiable) change localement les propriétés de la zone isolante (prise dans son ensemble) telle que vue par le film semi-conducteur Z1, Z2 ou Z4, par rapport aux propriétés du motif M3.

Bien entendu, on peut aussi considérer, en prenant l'un quelconque des motifs M1, M2 ou M4 comme référence, que chacun des autres lui correspond à part une modification du matériau de sa couche intermédiaire.

On peut donc analyser la structure de la figure 2 comme comportant des motifs ne différant que par leurs zones isolantes E1 à E4. Chacun de ces motifs comprend donc au moins une couche modifiable qui, dans l'exemple ici considéré, est intercalée entre une première couche isolante et une deuxième couche isolante, l'empilement et la couche semi-conductrice qui lui est superposée étant gravés au moins jusqu'à atteindre la deuxième couche isolante (à savoir la couche élémentaire inférieure) de façon à définir des motifs d'au moins deux types parmi les suivants :
- un type de motif où le matériau modifiable est laissé inchangé (par exemple le motif M3),
- un type de motif où le matériau modifiable est au moins partiellement altéré, par exemple par dopage ou par alliage (par exemple le motif M1 ou le motif M2),
- un type de motif où le matériau modifiable est au moins partiellement altéré d'une façon différente, notamment par dopage différent ou alliage différent (cas des motifs M1 et M2 comparés l'un à l'autre),
- un type de motif où le matériau modifiable est retiré (cas du motif M4 si l'on ne remplit pas le vide laissé par le retrait du matériau de la couche 13), et
- un type de motif où le matériau modifiable est retiré et remplacé par un autre matériau (cas du motif M4 où on remplit le vide laissé par le retrait du matériau 13)

On comprend aisément que les commentaires précités se généralisent au cas où il y a plusieurs couches intermédiaires entre les couches élémentaires supérieure et inférieure : il suffit de prévoir qu'il y ait une modification d'au moins l'une des couches intermédiaires pour conférer à un motif des propriétés différentes de celles d'un motif voisin. Par ailleurs il n'est pas nécessaire que les deux couches élémentaires inférieure et supérieure soient en matériau isolant ; il suffit que l'une d'entre eux le soit.

Dans l'exemple décrit ci-dessus, la couche intermédiaire est en matériau semi-conducteur, elle peut, en variante, être également en métal. Dans ce cas, sa modification peut résulter d'un remplacement local, ou d'un changement de phase cristalline, par exemple par traitement thermique, ou encore d'une oxydation ou de tout autre traitement engendrant une modification de nature de ladite couche.

Plus généralement, on peut également, en variante, modifier non pas la couche intermédiaire mais l'une des couches élémentaires inférieure ou supérieure. On prendra soin néanmoins, sachant que l'une au moins de ces couches est isolante, de maintenir intacte au moins une couche qui est isolante, parmi ces deux couches (celle de ces couches qui est isolante, lorsqu'une seule des couches inférieure et supérieure est isolante, ou l'une des deux couches inférieure et supérieure, lorsque chacune des deux est en matériau isolant).

En particulier, il pourra être intéressant, notamment pour des applications ESD, ou « electrostatic discharge », si la couche élémentaire inférieure 12 est en un matériau isolant et si la couche élémentaire supérieure 14 est aussi une couche isolante de remplacer localement cette dernière, par exemple par une couche électriquement conductrice (par exemple semi-conductrice, par exemple en silicium).

Il est possible également, dans le cas où les couches 12 et 14 sont toutes deux en matériau isolant, de modifier localement, au niveau d'un motif, la couche élémentaire inférieure 12. Par exemple, si la couche élémentaire inférieure 12 est initialement un oxyde, on pourra localement la remplacer par un matériau conducteur, par exemple du silicium. Ainsi, les motifs comportant du silicium au niveau de la couche élémentaire inférieure auront une couche intermédiaire 13 en contact électrique avec le substrat 11 alors que les motifs pour lesquels la couche isolante 12 aura été conservée conserveront entre la couche semi-conductrice 15 et le substrat 11 un isolant épais (12, 14).

On peut noter à la figure 2 que les portions résiduelles de la couche élémentaire supérieure et de la couche semi-conductrice des motifs M1 et M2 sont plus étroites que la couche sous-jacente correspondant à la couche intermédiaire d'origine. Cela permet de laisser libre une surface facilitant l'application d'un potentiel à chacune des couches intermédiaires de ces motifs. Bien entendu, une telle surface libre parallèle au substrat n'est pas essentielle pour permettre l'application d'un potentiel (à titre d'exemple, une telle surface libre n'existe pas dans le motif M3).

En effet, une structure finale selon l'invention permet des utilisations particulières. Des exemples, décrits dans le cas de la structure de la figure 2, sont mentionnés ci-dessous, en appelant V1 le potentiel appliqué à la couche intermédiaire du motif M1, V2 le potentiel appliqué à la couche intermédiaire du motif M2 et V3 le potentiel appliqué à la couche intermédiaire du motif M3.

Selon un premier exemple d'utilisation, les potentiels V1 et V2 sont à un potentiel déterminé, tandis que l'autre potentiel V3 est à un potentiel flottant.

Selon un second exemple d'utilisation, les premier et second potentiels V1 et V2 sont respectivement à des potentiels déterminés mais distincts (ceci permet d'activer ou de désactiver certains des motifs).

L'application d'un potentiel déterminé sur une couche modifiable d'un motif (c'est à dire la couche intermédiaire ou une des couches élémentaire supérieure ou inférieure) profite avantageusement de la présence d'une surface libre de contact. Cette surface libre peut être réalisée avantageusement dans une ouverture réalisée au cours de la gravure des motifs.

Les figures 3A à 3F représentent diverses étapes dans la fabrication d'une structure empilée uniforme et universelle conforme à la figure 1.

A la figure 3A, on part d'un substrat semi-conducteur 16, sur lequel on réalise une première couche, par exemple d'un matériau isolant (destinée à former la couche élémentaire supérieure 14) ; on réalise ensuite sur cette couche une deuxième couche 13, par exemple en matériau semi-conducteur (par exemple du silicium polycristallin) ou en métal (figure 3B).

On procède ensuite à la formation d'une troisième couche, par exemple d'isolant 12 (figure 3C). Sa nature est avantageusement choisie en sorte de favoriser la suite du procédé (voir la figure 3E) ; il s'agit avantageusement de silice (SiO₂), par exemple obtenu par oxydation thermique d'une partie de la couche 13 si on a choisi de réaliser cette couche 13 en silicium.

A la figure 3D est représenté le résultat d'étapes de formation d'une couche enterrée fragilisée 18. Ces étapes comportent typiquement un bombardement ionique avec au moins une espèce (typiquement de l'hydrogène et/ou de l'hélium) propre à former des cavités à une profondeur donnée, suivi d'un traitement thermique propre à favoriser la fragilisation de cette couche à l'aide des éléments ainsi introduits par bombardement. L'implantation peut avoir eu lieu avant la réalisation de la première couche ou entre la réalisation de cette première couche et la réalisation de la deuxième couche ou entre la réalisation de cette deuxième couche et celle de la troisième couche, ou après la réalisation de l'empilement de ces trois couches. La figure 3E représente une étape selon laquelle on colle sur la couche 12, de préférence par collage moléculaire, le substrat 11 destiné à former le substrat porteur de la structure empilée de la figure 1.

Deux traits tiretés 19 et 19' apparaissent sur cette figure 3E, pour schématiser deux niveaux possibles pour l'interface de collage, selon que le substrat 11 comporte lui-même une couche d'oxyde (cas schématisé par le trait tireté 19, qui est le plus bas) ou non (cas schématisé par le trait tireté 19', qui est le plus haut) ; il faut toutefois bien comprendre que cette différence de niveau n'est qu'une manière de distinguer visuellement les deux cas possibles, alors que le niveau de collage est bien sûr unique dans chacun des deux cas.

On peut rappeler ici que si les couches qui sont mises en contact de collage sont en oxyde de silicium, il en résulte de très bonnes qualités de collage et de tenue mécanique.

Dans l'exemple décrit ci-dessus, toutes les couches élémentaires 12, 13 et 14 sont réalisées sur le substrat 16. En variante non représentée, une partie de l'empilement est formée sur le substrat 16 et le reste de l'empilement est formé sur le substrat 11 ; il est en effet possible que tout ou partie de la couche 12, ou la couche 12 et tout ou partie de la couche 13, ou les couches 12 et 13 et tout ou partie de la couche 14, soi(en)t réalisé(s) sur le substrat support 11, le reste de ces couches étant, comme dans l'exemple décrit, réalisé sur le substrat 16. L'interface de collage se trouve ainsi reporté à l'intérieur de l'empilement 12, 13, 14, voire à l'interface avec le substrat 16.

Des étapes technologiques (notamment de nettoyage, de polissage, de localisation...) peuvent bien entendu être réalisées avant et/ou après chaque étape de réalisation des différentes couches élémentaires.

Enfin ainsi que cela est représenté à la figure 3F, un traitement de fracture, de nature thermique et/ou mécanique, de tout type connu approprié, permet de séparer le substrat 16 au niveau de la couche fragilisée 18, en un film mince semi-conducteur correspondant à celui repéré 15 à la figure 1 et un bloc de matériau semi-conducteur pouvant être recyclé pour de nouvelles étapes de formation de structures empilées telles que celle de la figure 1.

D'autres techniques d'amincissement du substrat 16 pourraient bien sûr être utilisées (par amincissement mécano-chimique, fracture au niveau d'une zone poreuse enterrée par exemple...).

Le matériau de la couche supérieure 14 est avantageusement isolant : il peut être obtenu par oxydation du semi-conducteur et/ou par les méthodes usuelles de dépôt (CVD, ALD) ou de croissance (MBE) de matériaux isolants (nitrures, oxydants, matériaux à grand gap comme le diamant, etc.). Son épaisseur est typiquement d'environ 1 nm à quelques centaines de nanomètres.

Le(s) matériau(x) de la(des) couche(s) intermédiaire(s) peut(peuvent) être également déposé(s) selon les mêmes méthodes. Son(leurs) épaisseur(s) varie(nt) dans la même gamme de valeurs.

Le matériau de la couche 14 est typiquement un isolant, tel qu'un oxyde SiO₂ déposé par CVD (ou obtenu par oxydation, si la couche intermédiaire est par exemple en silicium) et épais de quelques dizaines à quelques centaines de nanomètres.

Divers exemples peuvent être donnés à propos du choix du matériau dont on veut modifier les propriétés, pour permettre ensuite, lors de la modification (ou la personnalisation ou la spécialisation) de la structure empilée uniforme d'obtenir localement des propriétés particulières du point de vue conductivité électrique et/ou thermique.

Selon un premier mode de réalisation, le matériau modifiable est un matériau résistif électriquement (par exemple du silicium) qui est, lors des opérations de personnalisation, plus ou moins dopé au moins localement (par exemple par implantation ionique et activation thermique) dans au moins un de types de motifs de façon à changer sa conductivité et son travail de sortie dans le motif dopé.

Selon un second mode de réalisation, le matériau modifiable est un matériau résistif électriquement ou thermiquement qui est, lors des opérations de personnalisation, allié à un métal ou substitué par un métal de façon à améliorer sa conductivité électrique ou thermique ou son travail de sortie (par exemple du silicium siliciuré avec Ni ou Al).

Selon un troisième mode de réalisation, le matériau modifiable est un matériau semi-conducteur (par exemple silicium ou SiGe) qui peut, lors des opérations de personnalisation, être remplacé dans un des motifs par un matériau isolant (SiO₂ par ALD par exemple) ou par du vide.

Selon encore un autre mode de réalisation, le matériau modifiable est un matériau apte à changer de phase de façon à ce que, sous l'effet d'un traitement approprié, au moment des opérations de personnalisation, au moins un des types de motifs change d'état cristallin de façon à modifier sa conductivité (par exemple carbone résistif - cristallin ou amorphe - rendu plus conducteur par conversion en phase graphite).

Selon encore un autre mode de réalisation, le matériau modifiable est un matériau électriquement isolant (par exemple celui de la couche élémentaire inférieure ou supérieure) que l'on vient localement remplacer par un matériau électriquement conducteur.

Les figures 4A à 4G représentent diverses étapes d'un exemple de personnalisation de la structure empilée uniforme et universelle de la figure 1 en vue d'obtenir une structure finale personnalisée telle que celle représentée à la figure 4G.

On commence par préparer la structure empilée uniforme de la figure 1 (figure 4A), avec une couche 12 en SiO₂, une couche 13 en silicium polycristallin et une couche 14 en SiO₂ également (la couche 15 est ici encore en silicium) ; on recouvre ensuite la surface du film semi-conducteur 15 par une couche de nitrure 31 (figure 4B), typiquement en nitrure de silicium.

On dépose ensuite une couche de résine 32, dans laquelle on délimite par photolithographie des zones résiduelles qui résistent à une attaque de gravure, en sorte de créer une tranchée 33 dans l'empilement des couches jusqu'à la couche 13 (figure 4C).

On procède ensuite au retrait de la résine 32 et on forme des espaceurs 34 en nitrure le long des flancs de la tranchée puis on procède à la gravure du matériau de la couche 13 à proximité de la tranchée, laissant ainsi un volume 35 vide (figure 4D).

On remplit ensuite le vide 35 au moyen d'un matériau isolant 36, par exemple d'un oxyde de type HTO déposé par LPCVD (« Low Pressure Chemical Vapor Déposition ») aux alentours de 800°C avec une excellente conformité qui lui permet de remplir des cavités présentant des rapports d'aspect élevés (figure 4E).

Par gravure de l'oxyde ayant débordé hors de la tranchée et de la couche de nitrure 31, on obtient alors (figure 4F) une structure comportant en partie gauche la même superposition de couches que dans le substrat de départ, mais en ayant, en partie droite, une zone isolante entièrement formée de matériaux isolants.

On peut alors (figure 4G) compléter la structure par des plots permettant de tirer profit de ce que la structure comporte, en partie droite un isolant mince, et en partie gauche un isolant épais.

La figure 5 représente une structure 40, équivalente du point de vue électrique, obtenue par une technique conventionnelle. On observe qu'il comporte un substrat 41 présentant une variation d'épaisseur, une couche d'isolant discontinue 42 présentant une variation complémentaire d'épaisseur, et un film semi-conducteur 43, qui a nécessité de prendre en compte les performances de cette microstructures dès les premières étapes de fabrication. Or on a vu d'après les figures 4A à 4G qu'il est possible, grâce à l'invention, de réaliser une structure finale ayant les mêmes propriétés électriques, tout en ayant repoussé les adaptations spécifiques de la structure finale au-delà d'étapes significatives de fabrication (à savoir celles servant à la formation de la structure empilée uniforme universelle).

## Revendications

1. Procédé de fabrication d'une microstructure du type à semi-conducteur sur isolant et à motifs différenciés, comportant des étapes selon lesquelles :
• on réalise une structure empilée uniforme (10) du type à semi-conducteur sur isolant comportant une plaque formant substrat (11), une couche isolante continue longeant ce substrat et une couche semi-conductrice (15) longeant cette couche isolante en étant séparée du substrat par cette couche isolante, cette couche isolante continue étant formée d'un empilement d'au moins trois couches élémentaires, dont une couche élémentaire inférieure (12), au moins une couche élémentaire intermédiaire (13) et une couche élémentaire supérieure (14) longeant la couche semi-conductrice, l'une au moins parmi la couche élémentaire inférieure et la couche élémentaire supérieure étant en un matériau isolant,
• on forme, dans cette structure empilée uniforme, une pluralité d'au moins deux motifs (M1, M2, M3, M4) différenciés en modifiant l'une de ces couches élémentaires au sein de l'un de ces motifs de manière à ce que cette couche élémentaire présente une différence sensible de nature physique ou chimique entre ces deux motifs, l'une au moins des couches élémentaires inférieure et supérieure qui est en matériau isolant restant inchangée dans ces deux motifs.

2. Procédé selon la revendication 1, **caractérisé en ce qu'**on forme chacune des couches élémentaires inférieure et supérieure en des matériaux isolants.

3. Procédé selon la revendication1 ou la revendication 2, **caractérisé en ce que** la couche élémentaire que l'on modifie est une couche élémentaire intermédiaire.

4. Procédé selon l'une quelconque des revendications 1 à 3, **caractérisé en ce qu'**on forme la structure empilée uniforme selon des étapes selon lesquelles :
* on prépare un premier substrat (16) en un matériau semi-conducteur,
* on prépare un second substrat (11),
* on forme sur le premier et/ou sur le second substrat les couches élémentaires (12, 13, 14) dudit empilement,
* on assemble par collage le premier substrat (16) et le second substrat (11) en sorte que l'empilement se retrouve entre les deux substrats, la couche élémentaire supérieure (14) longeant le premier substrat (16) et la couche élémentaire inférieure (12) longeant le second substrat (11),
* on amincit le premier substrat semi-conducteur (16) en sorte de former ladite couche semi-conductrice (15) solidaire dudit ledit empilement.

5. Procédé selon la revendication 4, **caractérisé en ce que** l'on amincit le premier substrat (16) par fracture au niveau d'une zone fragile enterrée (18) préalablement formée

6. Procédé selon l'une quelconque des revendications 1 à 5, **caractérisé en ce que** ladite couche élémentaire que l'on modifie au sein d'un motif est en matériau semi-conducteur et la modification de cette couche élémentaire comporte une étape de dopage.

7. Procédé selon l'une quelconque des revendications 1 à 6, **caractérisé en ce que** ladite couche élémentaire que l'on modifie au sein d'un motif est en matériau semi-conducteur et la modification de cette couche élémentaire comporte une étape d'introduction d'éléments d'alliage.

8. Procédé selon l'une quelconque des revendications 1 à 7, **caractérisé en ce que** ladite couche élémentaire que l'on modifie au sein d'un motif est en matériau semi-conducteur ou en métal et la modification de cette couche élémentaire comporte une étape consistant à changer la phase cristalline du matériau de cette couche élémentaire.

9. Procédé selon l'une quelconque des revendications 1 à 8, **caractérisé en ce que** ladite modification de la couche élémentaire d'un motif comporte une étape consistant à retirer localement ladite couche élémentaire.

10. Procédé selon la revendication 9, **caractérisé en ce que** la modification de ladite couche élémentaire comporte en outre une étape consistant à remplir par un nouveau matériau l'espace laissé par le retrait local de la couche élémentaire.
